# EUROPEAN PATENT APPLICATION

(11) **EP 4 145 428 A1**
(43) Date of publication of application: **08.03.2023**
(21) Application number: 21803031.0
(22) Date of filing: 31.03.2021
(51) Int. Cl.: G09F 9/30, H05K 5/02

(54) **ELECTRONIC DEVICE**

(30) Priority: 12.05.2020 CN 202010398352
(71) Applicant: GUANGDONG OPPO MOBILE TELECOMMUNICATIONS CORP., LTD., Dongguan, Guangdong 523860 (CN)
(72) Inventor: SHEN, Liekang, Dongguan, Guangdong 523860 (CN); ZENG, Chuanhua, Dongguan, Guangdong 523860 (CN); GUO, Jiang, Dongguan, Guangdong 523860 (CN)
(74) Representative: Fassio, Valeria
(86) International application number: PCT/CN2021/084527
(87) International publication number: WO 2021/227689

(57) **Abstract**

An electronic device (20), comprising a driving mechanism (260) and a first housing (210) and a second housing (220) that are rotatably connected; the first housing (210) is provided with a first magnetic mechanism (240); the second housing (220) is provided with a second magnetic mechanism (250); the driving mechanism (260) is connected to the second magnetic mechanism (250), and the driving mechanism (260) is used to drive the second magnetic mechanism (250) to move so that the second magnetic mechanism (250) and the first magnetic mechanism (240) are attracted together or repel one another to separate, thereby driving the first housing (210) and the second housing (220) to rotate relative to one another.

## Description

The present disclosure claims priority to Chinese patent application No. 202010398352.2, filed on May 12, 2020, entitled "ELECTRONIC DEVICE", the entire content of the above-mentioned application is hereby incorporated herein by reference.

### TECHNICAL FIELD

The present disclosure relates to the field of electronic technologies, and more particular, to an electronic device.

### BACKGROUND

Foldable devices are widely favored by users because they can not only meet needs of the users for large-size screens, but also avoid inconvenience of carrying caused by large-sized screens. The foldable devices usually require the users to manually unfold or fold.

### SUMMARY

An embodiment of the present disclosure provides an electronic device, which can realize automatic unfolding or folding of a foldable electronic device.

The embodiment of the disclosure provides an electronic device, including:
a first housing, provided with a first magnetic mechanism;
a second housing, rotatably connected to the first housing, and wherein the second housing is provided with a second magnetic mechanism; and
a driving mechanism, connected to the second magnetic mechanism; wherein the driving mechanism is configured to drive the second magnetic mechanism to move to have the second magnetic mechanism and the first magnetic mechanism mutually attracted together or mutually repelled to be separated from each other and thereby to drive the first housing and the second housing to rotate relatively to each other.

An embodiment of the present disclosure provides an electronic device, including:
a first housing, provided with a first magnetic mechanism;
a second housing, rotatably connected to the first housing, and the second housing being provided with a second magnetic mechanism; and
a driving mechanism, configured to drive the second magnetic mechanism to move on the second housing; and
a processor, electrically connected to the driving mechanism;
wherein the processor is configured to control, based on different signals, the driving mechanism to drive the second magnetic mechanism to move to different positions and thereby to have the second magnetic mechanism and the first magnetic mechanism mutually attracted together or mutually repelled to be separated from each other.

In embodiments of the present disclosure, the driving mechanism can be used to control the second magnetic mechanism to move to have the first magnetic mechanism and the second magnetic mechanism mutually attracted together or mutually repelled to be separated from each other, which can make the first housing and the second housing rotate relatively to each other to realize the automatic unfolding or folding of the foldable electronic device.

### BRIEF DESCRIPTION OF THE DRAWINGS

FIG. 1 illustrates a first schematic structural diagram of an electronic device in a folded state according to an embodiment of the present disclosure.
FIG. 2 illustrates a schematic structural diagram of an electronic device in an unfolded state according to an embodiment of the present disclosure.
FIG. 3 illustrates a second schematic structural diagram of an electronic device in a folded state according to an embodiment of the present disclosure.
FIG. 4 illustrates a schematic cross-sectional structural diagram of the electronic device illustrated in FIG. 3 taken along a P1-P1 direction.
FIG. 5 illustrates a first schematic structural diagram of a first magnetic mechanism and a second magnetic mechanism mutually attracted together in the electronic device illustrated in FIG. 4.
FIG. 6 illustrates a first schematic structural diagram of the first magnetic mechanism and the second magnetic mechanism mutually repelled to be separated from each other in the electronic device illustrated in FIG. 4.
FIG. 7 illustrates a schematic structural diagram of a driving mechanism and a second magnetic mechanism in the electronic device illustrated in FIG. 4.
FIG. 8 illustrates a third schematic structural diagram of an electronic device in a folded state according to an embodiment of the present disclosure.
FIG. 9 illustrates a schematic cross-sectional structural diagram of the electronic device illustrated in FIG. 8 taken along a P2-P2 direction.
FIG. 10 illustrates a schematic structural diagram of an area A in the electronic device illustrated in FIG. 9.
FIG. 11 illustrates a second schematic structural diagram of a first magnetic mechanism and a second magnetic mechanism mutually attracted together in the electronic device illustrated in FIG. 4.
FIG. 12 illustrates a second schematic structural diagram of the first magnetic mechanism and the second magnetic mechanism mutually repelled to be separated from each other in the electronic device illustrated in FIG. 4.

### DETAILED DESCRIPTION OF EMBODIMENTS

An embodiment of the disclosure provides an electronic device including:
a first housing, provided with a first magnetic mechanism;
a second housing, rotatably connected to the first housing, and wherein the second housing is provided with a second magnetic mechanism; and
a driving mechanism, connected to the second magnetic mechanism; wherein the driving mechanism is configured to drive the second magnetic mechanism to move to have the second magnetic mechanism and the first magnetic mechanism mutually attracted together or mutually repelled to be separated from each other and thereby to drive the first housing and the second housing to rotate relatively to each other.

In an illustrated embodiment of the present disclosure, the first magnetic mechanism includes: at least two first magnetic elements arranged side by side, and magnetic poles of adjacent two of the at least two first magnetic elements are unlike magnetic poles; the second magnetic mechanism includes: at least two second magnetic elements arranged side by side, and magnetic poles of adjacent two of the at least two second magnetic elements are unlike magnetic poles; the driving mechanism is configured to drive the at least two second magnetic elements to move between a first position and a second position to make the at least two second magnetic elements each correspond to different ones of the at least two first magnetic elements, and thereby magnetic poles of at least some of the at least two second magnetic elements and the first magnetic elements corresponding thereto are unlike magnetic poles when the at least two second magnetic elements are located at the first position, and magnetic poles of at least some of the at least two second magnetic elements and the first magnetic elements corresponding thereto are like magnetic poles when the at least two second magnetic elements are located at the second position.

In an illustrated embodiment of the present disclosure, a number of the first magnetic elements in the first magnetic mechanism is one more than a number of the second magnetic elements in the second magnetic mechanism.

In an illustrated embodiment of the present disclosure, adjacent two of the at least two second magnetic elements are abutted against each other; or adjacent two of the at least two second magnetic elements are spaced apart from each other.

In an illustrated embodiment of the present disclosure, adjacent two of the at least two first magnetic elements are abutted against each other; or adjacent two of the at least two first magnetic elements are spaced apart from each other.

In an illustrated embodiment of the present disclosure, a thickness of one of the first magnetic elements is the same as a thickness of one of the second magnetic elements.

In an illustrated embodiment of the present disclosure, the first magnetic mechanism includes: at least two first magnetic elements arranged side by side, and magnetic poles of adjacent two of the at least two first magnetic elements are unlike magnetic poles; the second magnetic mechanism includes: one second magnetic element; the driving mechanism is configured to drive the second magnetic element to move between a first position and a second position to make the second magnetic element correspond to different ones of the at least two first magnetic elements and thereby a magnetic pole of the second magnetic element and a magnetic pole of the first magnetic element corresponding thereto are unlike magnetic poles when the second magnetic element is located at the first position, and a magnetic pole of the second magnetic element and a magnetic pole of the first magnetic element corresponding thereto are like magnetic poles when the second magnetic element is located at the second position.

In an illustrated embodiment of the present disclosure, magnetic intensities of the first magnetic elements arranged at different positions are different in the at least two first magnetic elements arranged side by side.

In an illustrated embodiment of the present disclosure, the driving mechanism includes a bracket and a driving element connected to the bracket, the second magnetic mechanism is disposed on the bracket, and the driving element is configured to drive the bracket to move and thereby to make the second magnetic mechanism move following the bracket.

In an illustrated embodiment of the present disclosure, the second housing is provided with a limit groove, the bracket is provided with a limit block, the limit block is disposed in the limit groove, and the limit groove is configured to cooperate with the limit block to limit a movement track of the bracket.

In an illustrated embodiment of the present disclosure, the driving mechanism further includes an elastic element, an end of the elastic element is connected to the bracket, another end of the elastic element abuts against the second housing, and the elastic element is configured to generate elastic deformation and thereby to switch between a compressed state and an extended state; the elastic element is deformed to be in the compressed state and the bracket is moved to a preset position when the driving element drives the bracket to move; and the elastic element is switched from the compressed state to the extended state and the bracket moves to an initial position when the driving element does not drive the bracket to move.

In an illustrated embodiment of the present disclosure, the bracket is connected to the elastic element through a first connection element, and the first connection element is configured to limit a deformation direction of the elastic element.

In an illustrated embodiment of the present disclosure, the first connection element is disposed on a side wall of the bracket and protrudes from the side wall of the bracket, the elastic element is provided with a first through hole, a portion of the elastic element is sleeved on the first connection element through the first through hole, and another portion of the elastic element is exposed outside.

In an illustrated embodiment of the present disclosure, a number of each of the first connection element and the elastic element is two, and the two elastic elements are spaced apart from each other and sleeved on the two first connection elements respectively.

In an illustrated embodiment of the present disclosure, the driving mechanism further includes a towing element connected to the driving element, the bracket further includes a second connection element, the second connection element is disposed between the two first connection elements, the second connection element is connected to the towing element, and the driving element is configured to drive the towing element to tow the bracket to move.

In an illustrated embodiment of the present disclosure, the towing element is provided with a second through hole, and the second connection element is sleeved in the second through hole.

In an illustrated embodiment of the present disclosure, the driving mechanism includes a rotating shaft and a driving element, the rotating shaft is connected to the second magnetic mechanism, and the driving element is configured to drive the second magnetic mechanism to rotate around the rotating shaft and thereby make magnetic poles of the second magnetic mechanism and the first magnetic mechanism be switched between unlike magnetic poles and like magnetic poles.

Another embodiment of the present disclosure relates to an electronic device, and the electronic device includes:
a first housing, provided with a first magnetic mechanism;
a second housing, rotatably connected to the first housing, and the second housing being provided with a second magnetic mechanism; and
a driving mechanism, configured to drive the second magnetic mechanism to move on the second housing; and
a processor, electrically connected to the driving mechanism;
the processor is configured to control, based on different signals, the driving mechanism to drive the second magnetic mechanism to move to different positions and thereby to have the second magnetic mechanism and the first magnetic mechanism mutually attracted together or mutually repelled to be separated from each other.

In an illustrated embodiment of the present disclosure, the first magnetic mechanism includes: at least two first magnetic elements arranged side by side, and magnetic poles of adjacent two of the at least two first magnetic elements are unlike magnetic poles; the second magnetic mechanism includes: at least two second magnetic elements arranged side by side, and magnetic poles of adjacent two of the at least two second magnetic elements are unlike magnetic poles; the driving mechanism is configured to control, based on the different signals, the driving mechanism to drive the second magnetic mechanism to move between a first position and a second position to make the second magnetic elements each correspond to different ones of the at least two first magnetic elements and thereby magnetic poles of at least some of the at least two second magnetic elements and the first magnetic elements corresponding thereto are unlike magnetic poles when the at least two second magnetic elements are located at the first position, and magnetic poles of at least some of the at least two second magnetic elements and the first magnetic elements corresponding thereto are like magnetic poles when the at least two second magnetic elements are located at the second position.

In an illustrated embodiment of the present disclosure, the driving mechanism includes a bracket, a driving element and an elastic element connected to one another, the second magnetic mechanism is disposed on the bracket, the driving element is configured to drive the bracket to move and thereby make the second magnetic mechanism move following the bracket; an end of the elastic element is connected to the bracket, another end of the elastic element abuts against the second housing, and the elastic element is configured to generate elastic deformation and thereby switch between a compressed state and an extended state; the processor is configured to: receive a third signal and control based on the third signal the driving element to drive the bracket to move to a first position and press the elastic element to make the elastic element be switched to the compressed state, and thereby an attractive force is generated between the second magnetic mechanism and the first magnetic mechanism 240; receive a fourth signal and control based on the fourth signal the driving element to drive the bracket to move to a second position and thereby make the elastic element be switched to the extended state, and thereby a repulsive force is generated between the second magnetic mechanism and the first magnetic mechanism 240.

The technical solutions in the embodiments of the present disclosure will be clearly and completely described below in combination with the drawings in the embodiments of the present disclosure. Obviously, the described embodiments are only some of the embodiments of the present disclosure, not all of the embodiments. Based on the embodiments in the present disclosure, all other embodiments obtained by those skilled in the art without making creative labor belong to the scope of protection of the present disclosure.

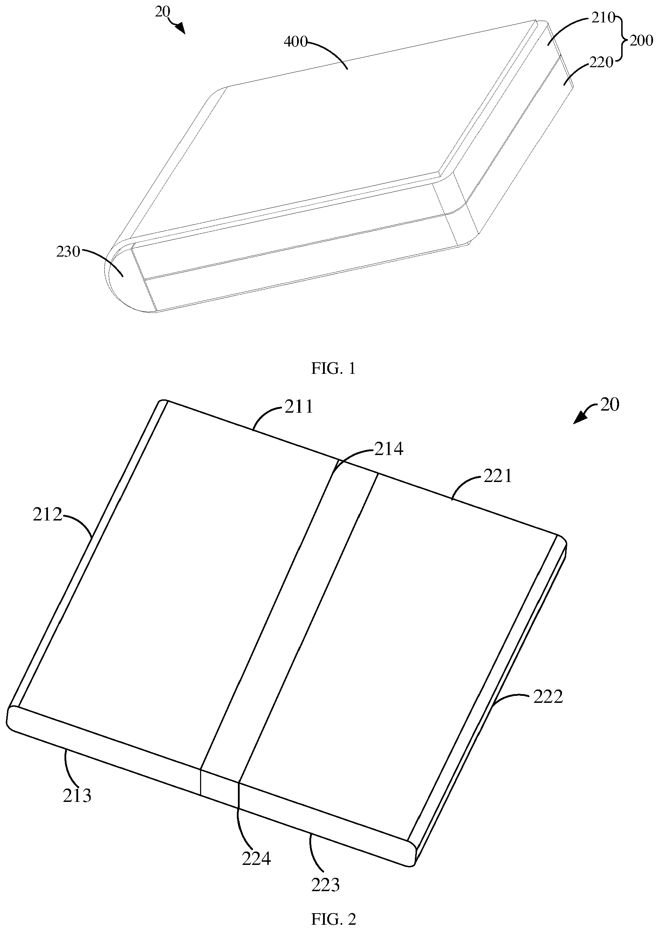

Please refer to FIG. 1 and FIG. 2, FIG. 1 illustrates a first schematic structural diagram of an electronic device in a folded state according to an embodiment of the present disclosure, and FIG. 2 illustrates a schematic structural diagram of an electronic device in an unfolded state according to an embodiment of the present disclosure. An electronic device such as an electronic device 20 illustrated in FIG. 1 may be a computing device such as a laptop, a computer monitor including an embedded computer, a tablet computer, a cellular phone, a media player, a handheld or portable electronic device, a smaller device (such as a wristwatch device, a hanging device, an earphone or earpiece device, a device embedded in glasses or a device worn on a user's head, or one of other wearable and micro devices), a television, a computer display that does not include an embedded computer, a game device, a navigation device, an embedded system (such as a system in which an electronic device with a display is installed in a kiosk or a car), a device that implements the functions of two or more of these devices, or one of other electronic devices. In the illustrated configuration of FIG. 1, the electronic device 20 is a portable device, such as a cellular phone, a media player, a tablet computer, or other portable computing devices. Other configurations may be used for the electronic device 20 if desired, and FIG. 1 is illustrative only.

The electronic device 20 such as that described above may be configured as a foldable device. The foldable device may include a foldable housing assembly such as a housing assembly 200, the housing assembly 200 is used to form an outer contour of the foldable device. The housing assembly 200 may include a plurality of connected housings, for example, the housing assembly 200 may include a first housing such as a first housing 210 and a second housing such as a second housing 220. The second housing 220 is connected to the first housing 210 through a rotating element such as a rotating element 230, and the second housing 220 may rotate around the rotating element 230, thus the first housing 210 and the second housing 220 can be switched between a folded state and an unfolded state. When the first housing 210 and the second housing 220 are in the folded state, the first housing 210 and the second housing 220 are mutually attached together (as illustrated in FIG. 1), so that an occupied space of the electronic device 20 can be smaller, which facilitates the carrying and storage of the electronic device 20. When the first housing 210 and the second housing 220 are in the unfolded state, the first housing 210 and the second housing 220 are far away from each other (as illustrated in FIG. 2), which can make the electronic device 20 have a larger display area, thereby facilitating the user's operation of the electronic device 20 and watching. It should be noted that the second housing 220 may have one rotating direction, and the electronic device 20 can be folded unidirectionally at this time; or the second housing 220 may have two rotating directions, and the electronic device 20 may be folded in two directions.

The first housing 210 and the second housing 220 may be formed of plastic, glass, ceramic, fiber composite material, metal (e.g., stainless steel, aluminum, etc.), other suitable materials, or any combination of two or more of these materials. The first housing 210 and the second housing 220 may be formed using an integrated configuration in which some or all of the first housing 210 and the second housing 220 are processed or molded into a single structure, or may be formed using a plurality of structures (e.g., an inner frame structure, one or more structures forming an outer housing surface, etc.). It should be noted that structures and manufacturing materials of the first housing 210 and the second housing 220 may be the same or different.

As illustrated in FIG. 2, the first housing 210 may have a regular shape, such as a rounded rectangular structure. The first housing 210 may include a plurality of connected sides, for example, the first housing 210 may include a first side 211, a second side 212, a third side 213, and a fourth side 214 that are sequentially connected to one another in that order. The first side 211 is opposite to the third side 213, and the second side 212 is opposite to the fourth side 214. The first side 211 is located at a top of the electronic device 20, the third side 213 is located at a bottom of the electronic device 20, the second side 212 is located at a side (or an edge position of the side) of the electronic device 20, and the fourth side 214 is used to connect to the rotating element 230.

The second housing 220 may have a regular shape, such as a rounded rectangular structure. Of course, the shape of the second housing 220 may be the same as that of the first housing 210 or may be different from that of the first housing 210. The second housing 220 may include a plurality of connected sides, for example, the second housing 220 may include a fifth side 221, a sixth side 222, a seventh side 223, and an eighth side 224 that are sequentially connected to one another in that order. The fifth side 221 is opposite to the seventh side 223, and the sixth side 222 is opposite to the eighth side 224. The fifth side 221 and the first side 211 are located at the same side of the electronic device 20, that is, the fifth side 221 is also located at the top of the electronic device 20. The seventh side 223 and the third side 213 are located at the same side of the electronic device 20, that is, the seventh side 223 is also located at the bottom of the electronic device 20. The sixth side 222 is opposite to the second side 212 of the first housing 210, and the sixth side 222 is located at another side of the electronic device. The eighth side 224 is connected to the rotating element 230. It can be understood that the rotating element 230 is connected between the eighth side 224 and the fourth side 214 of the first housing 210.

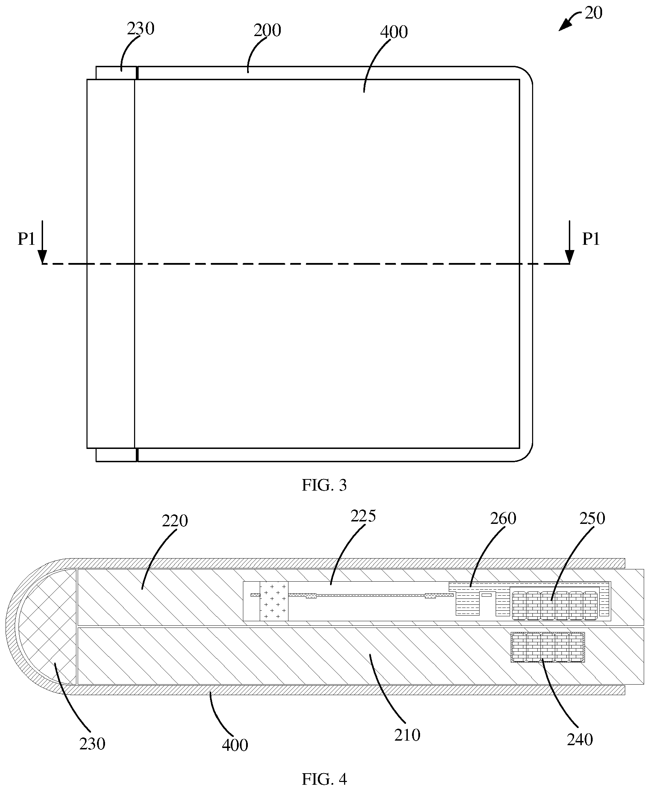

As illustrated in FIG. 3 and FIG. 4, FIG. 3 illustrates a second schematic structural diagram of an electronic device in a folded state according to an embodiment of the present disclosure, and FIG. 4 illustrates a schematic structural diagram of the electronic device illustrated in FIG. 3 taken along a P-P direction. The housing assembly 200 may further include a first magnetic mechanism, such as a first magnetic mechanism 240, and a second magnetic mechanism, such as a second magnetic mechanism 250. The first magnetic mechanism 240 may be disposed on the first housing 210, for example, it may be realized by gluing, riveting, screwing, or other methods. The second magnetic mechanism 250 may be disposed on the second housing 220. When the electronic device 20 is in the folded state, at least a part of a projection of the second magnetic mechanism 250 on the first housing 210 overlaps with the first magnetic mechanism 240. For example, the projection of the second magnetic mechanism 250 on the first housing 210 completely overlaps with the first magnetic mechanism 240, at this time, a size of the projection of the second magnetic mechanism 250 on the first housing 210 is the same as a size of the first magnetic mechanism 240; or only a part of the projection of the second magnetic mechanism 250 on the first housing 210 overlaps with the first magnetic mechanism 240.

The housing assembly 200 may further include a driving mechanism 260, the driving mechanism 260 is connected to the second magnetic mechanism 250, and the driving mechanism 260 may be used to drive the second magnetic mechanism 250 to move to change a position of the second magnetic mechanism 250 and thereby to make the second magnetic mechanism 250 and the first magnetic mechanism 240 switch between a state of attracted together and a state of repelled to be separated from each other. For example, in an initial state, a magnetism of the first magnetic mechanism 240 is opposite to that of the second magnetic mechanism 250, at this time, the first magnetic mechanism 240 and the second magnetic mechanism 250 are mutually attracted together, the first housing 210 and the second housing 220 are mutually attached together by an attractive force, and the first housing 210 and the second housing 220 are kept in the folded state. When the user needs to unfold the electronic device 20, the electronic device 20 can control the driving mechanism 260 to drive the second magnetic mechanism 250 to move to change the magnetism of the second magnetic mechanism 250 and the first magnetic mechanism 240 from the same to the opposite, at this time, a repulsive force is generated between the first housing 210 and the second housing 220, therefore the first housing 210 and the second housing 220 are unfolded at a certain angle, which is convenient for the user to separate the first housing 210 and the second housing 220, at this time, the first housing 210 and the second housing 220 are switched from the folded state to the unfolded state. Similarly, when the user needs to fold the electronic device 20, the electronic device 20 can control the driving mechanism 260 to drive the second magnetic mechanism 250 to move to change the magnetism of the second magnetic mechanism 250 and the first magnetic mechanism 240 from the opposite to the same, at this time, an attractive force is generated between the first housing 210 and the second housing 220, therefore the first housing 210 and the second housing 220 are mutually attached together and are not easily separated, at this time, the first housing 210 and the second housing 220 are switched from the unfolded state to the folded state.

The electronic device 20 may further include a processor, the processor is electrically connected to the driving mechanism 260, and the processor may be used to control working states of the driving mechanism 260. The processor may be configured to control, based on different signals, the driving mechanism 260 to drive the second magnetic mechanism to move to different positions and thereby to have the first magnetic mechanism 240 and the second magnetic mechanism 250 mutually attracted together or mutually repelled to be separated from each other. For example, the processor may receive a first signal and control, based on the first signal, the second magnetic mechanism 250 to move to a first position, at this time, an attractive force can be generated between the second magnetic mechanism 250 and the first magnetic mechanism 240, the second magnetic mechanism 250 and the first magnetic mechanism 240 are mutually attracted together, and the first housing 210 and the second housing 220 rotate relatively to each other in a direction of mutual attachment, and thus the first housing 210 and the second housing 220 are kept in the folded state. The processor may receive a second signal and control, based on the second signal, the second magnetic mechanism 250 to move to a second position, at this time, a repulsive force can be generated between the second magnetic mechanism 250 and the first magnetic mechanism 240, the second magnetic mechanism 250 and the first magnetic mechanism 240 are mutually repelled to be separated from each other, and the first housing 210 and the second housing 220 rotate relatively to each other in a direction of mutual separating, and thus the first housing 210 and the second housing 220 may unfolded at a certain angle.

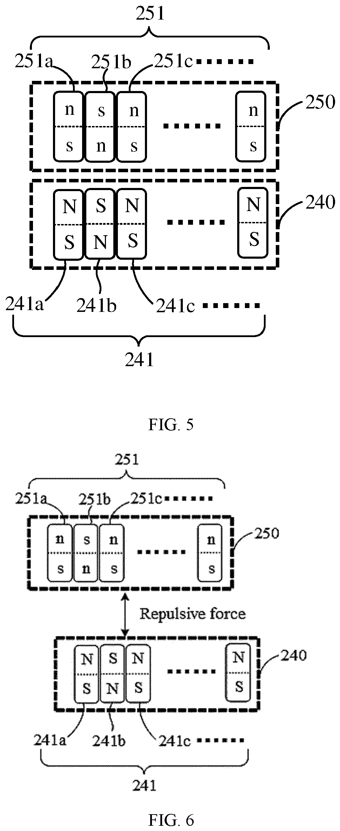

As illustrated in FIG. 5 and FIG. 6, FIG. 5 illustrates a first schematic structural diagram of a first magnetic mechanism and a second magnetic mechanism mutually attracted together in the electronic device illustrated in FIG. 4, and FIG. 6 illustrates a first schematic structural diagram of the first magnetic mechanism and the second magnetic mechanism mutually repelled to be separated from each other in the electronic device illustrated in FIG. 4. The first magnetic mechanism 240 may include at least two first magnetic elements 241 arranged side by side. Two adjacent first magnetic elements 241 of the at least two first magnetic elements 241 are adjacent to each other, and magnetic poles of the two adjacent first magnetic elements 241 are unlike magnetic poles, so as to make the two adjacent first magnetic elements 241 be mutually attracted together, i.e., attached to each other. An embodiment of the present disclosure are exemplified by three first magnetic elements. The first magnetic mechanism 240 may include a first magnetic element 241a, a first magnetic element 241b, and a first magnetic element 241c arranged side by side. The first magnetic element 241a includes a first magnetic pole (such as a S pole illustrated in FIGS. 5 and 6) and a second magnetic pole (such as a N pole illustrated in FIGS. 5 and 6) with opposite magnetism. The first magnetic pole faces toward an outside of the first housing 210 from an inside of the first housing 210, and the second magnetic pole faces toward the inside of the first housing 210 from the outside of the first housing 210. The first magnetic element 241b includes a first magnetic pole and a second magnetic pole. The second magnetic pole of the first magnetic element 241b and the first magnetic pole of the first magnetic element 241a are adjacent to each other, and the first magnetic pole of the first magnetic element 241b and the second magnetic pole of the first magnetic element 241a are adjacent to each other, which can make the first magnetic element 241a and the first magnetic element 241b be mutually attracted together by an attractive force. The first magnetic element 241c includes a first magnetic pole and a second magnetic pole. The first magnetic pole of the first magnetic element 241c and the second magnetic pole of the first magnetic element 241b are adjacent to each other, and the second magnetic pole of the first magnetic element 241c and the first magnetic pole of the first magnetic element 241b are adjacent to each other, which can make the first magnetic element 241c and the first magnetic element 241b be mutually attracted together by an attractive force. Specifically, the first magnetic element 241 may be a strip-shaped structure, and the first magnetic element 241 includes two opposite ends, the first magnetic pole may be formed at one of the two opposite ends, and the second magnetic pole may be formed at the other end. It should be noted that the first magnetic element 241 may also have other structures, such as a U-shaped structure.

The second magnetic mechanism 250 includes at least two second magnetic elements 251 arranged side by side. Two adjacent second magnetic elements 251 of the at least two second magnetic elements 251 are adjacent to each other, and magnetic poles of one second magnetic element 251 and the other second magnetic element 251 in the two adjacent second magnetic elements 251 are unlike magnetic poles to make the two adjacent second magnetic elements 251 be mutually attracted together. The embodiment of the present disclosure is exemplified by three second magnetic elements. The second magnetic mechanism 250 may include a second magnetic element 251a, a second magnetic element 251b, and a second magnetic element 251c arranged side by side. The second magnetic element 251a includes a third magnetic pole (such as a n pole illustrated in FIGS. 5 and 6) and a fourth magnetic pole (such as a s pole illustrated in FIGS. 5 and 6) with opposite magnetism. The third magnetic pole faces toward the outside of the second housing 220 from an inside of the second housing 220, and the fourth magnetic pole faces toward the inside of the second housing 220 from the outside of the second housing 220. The second magnetic element 251b includes a third magnetic pole and a fourth magnetic pole. The fourth magnetic pole of the second magnetic element 251b and the third magnetic pole of the second magnetic element 251a are adjacent to each other, and the third magnetic pole of the second magnetic element 251b and the third magnetic pole of the second magnetic element 251a are adjacent to each other, which can make the second magnetic element 251a and the second magnetic element 251b are mutually attracted together by an attractive force. The second magnetic element 251c includes a third magnetic pole and a fourth magnetic pole. The third magnetic pole of the second magnetic element 251c and the fourth magnetic pole of the second magnetic element 251b are adjacent to each other, and the fourth magnetic pole of the second magnetic element 251c and the fourth magnetic pole of the second magnetic element 251b are adjacent to each other, which can make the second magnetic element 251c and the second magnetic element 251b be mutually attracted together by an attractive force. Specifically, the second magnetic element 251 may be a strip-shaped structure, the second magnetic element 251 includes two opposite ends, the third magnetic pole may be formed at one of the two opposite ends, and the fourth magnetic pole may be formed at the other end. It should be noted that the second magnetic element 251 may also have other structures, such as a U-shaped structure.

It should be noted that the structure of the second magnetic element 251 of the second magnetic mechanism 250 may be the same as the structure of the first magnetic element 241 of the first magnetic mechanism 240; or the structures of the second magnetic element 251 and the first magnetic element 241 may be different. The number of the second magnetic elements 251 of the second magnetic mechanism 250 may be the same as or different from the number of the first magnetic elements 241 of the first magnetic mechanism 240.

In some embodiments, the number of the first magnetic elements 241 in the first magnetic mechanism 240 is one more than the number of the second magnetic elements 251 in the second magnetic mechanism 250. For example, when the number of the first magnetic elements 241 in the first magnetic mechanism 240 is four, the number of the second magnetic elements 251 in the second magnetic mechanism 250 is three. Thus, when the driving mechanism 260 drives the second magnetic mechanism 250 to move left or right in a direction parallel to the second housing 220, it can ensure that all the second magnetic elements 251 in the second magnetic mechanism 250 each have at least one the first magnetic element 241 corresponding thereto, during the movement of the second magnetic mechanism 250, all the second magnetic elements 251 can be in a working state, and the second magnetic elements 251 can be used better.

When the first housing 210 and the second housing 220 are in the folded state, the first magnetic elements 241 correspond to at least some of the second magnetic elements 251 one-to-one, magnetic poles of the first magnetic element 241 and the second magnetic element 251 corresponding thereto are unlike magnetic poles, an attractive force can be generated between the first magnetic mechanism 240 and the second magnetic mechanism 250 and thereby the first housing 210 and the second housing 220 are kept in the folded state. When the electronic device 20 needed to be unfold, the electronic device 20 may control the driving mechanism 260 to drive the second magnetic elements 251 to move from the first position to the second position. When the second magnetic elements 251 are located at the first position, the magnetic poles of the second magnetic element 251 and the first magnetic element 241 corresponding thereto are unlike magnetic poles, and the first magnetic mechanism 240 and the second magnetic mechanism 250 are mutually attracted together. When the second magnetic elements 251 are located at the second position, the magnetic poles of the second magnetic element 251 and the first magnetic element 241 corresponding thereto are like magnetic poles, at this time, the first magnetic mechanism 240 and the second magnetic mechanism 250 are mutually repelled to be separated from each other. It can be understood that when the second magnetic elements 251 move from the first position to the second position, the first magnetic mechanism 240 and the second magnetic mechanism 250 are switched from the state of being attracted together to the state of being repelled to be separated from each other, thus a repulsive force is generated between the first housing 210 and the second housing 220 to make the first housing 210 and the second housing 220 be unfold at a certain angle (such as 15 degrees, 20 degrees or 30 degrees), which can facilitate the user to manually unfold the electronic device 20.

For example, when the first housing 210 and the second housing 220 are in the folded state, the first magnetic element 241a corresponds to the second magnetic element 251a, the first magnetic element 241b corresponds to the second magnetic element 251b, and the first magnetic element 241c corresponds to the second magnetic element 251c. After the driving mechanism 260 drives the second magnetic mechanism 250 from the first position to the second position, original corresponding relationships between the first magnetic elements 241 and the second magnetic elements 251 are broken. For example, after the second magnetic mechanism 250 is moved from the first position to the second position, the first magnetic element 241a may correspond to the second magnetic element 251b, at this time, the second magnetic pole of the first magnetic element 241a correspond to the third magnetic pole of the second magnetic element 251b, that is, the second magnetic pole of the first magnetic element 241a and the third magnetic pole of the second magnetic element 251b are like magnetic poles, and a repulsive force can be generated between the like magnetic poles. Of course, after the second magnetic mechanism 250 is moved, the first magnetic element 241a may correspond to the other second magnetic elements 251.

When the electronic device 20 needed to be fold, the electronic device 20 can control the driving mechanism 260 to drive the second magnetic elements 251 to move from the second position to the first position. At this time, the first magnetic mechanism 240 and the second magnetic mechanism 250 are switched from the state of being repelled to be separated from each other to the state of being attracted together, an attractive force can be generated between the first housing 210 and the second housing 220 to keep the first housing 210 and the second housing 220 to be attached to each other, which can facilitate the user to store the electronic device 20, and it is also possible to prevent the first housing 210 and the second housing 220 from being unfolded when the user does not need to do that to spoil the user experience. For example, when the first housing 210 and the second housing 220 are in the unfolded state, the first magnetic element 241a corresponds to the second magnetic element 251b, and the first magnetic element 241c corresponds to the second magnetic element 251c. After the driving mechanism 260 drives the second magnetic elements 251 from the second position to the first position, the corresponding relationships between the first magnetic elements 241 and the second magnetic elements 251 are broken. For example, after the second magnetic mechanism 250 is moved, the first magnetic element 241a corresponds to the second magnetic element 251a, the first magnetic element 241b corresponds to the second magnetic element 251b, and the first magnetic element 241c corresponds to the second magnetic element 251c, at this time, the second magnetic pole of the first magnetic element 241a corresponds to the fourth magnetic pole of the second magnetic element 251a, the first magnetic pole of the first magnetic element 241b corresponds to the third magnetic pole of the second magnetic element 251b, the second magnetic pole of the first magnetic element 241c corresponds to the fourth magnetic pole of the second magnetic element 251c, that is, the second magnetic pole of the first magnetic element 241a and the fourth magnetic pole of the second magnetic element 251a are unlike magnetic poles, the first magnetic pole of the first magnetic element 241b and the third magnetic pole of the second magnetic element 251b are unlike magnetic poles, the second magnetic pole of the first magnetic element 241c and the fourth magnetic pole of the second magnetic element 251c are unlike magnetic poles, an attractive force can be generated between the unlike magnetic poles. Of course, after the second magnetic mechanism 250 is moved, the first magnetic element 241a, the first magnetic element 241b, and the first magnetic element 241c may correspond to the other second magnetic elements 251, respectively.

It should be noted that when the two adjacent second magnetic elements 251 of the at least two second magnetic elements 251 are adjacent to each other, the two adjacent first magnetic elements 241 of at least two first magnetic elements 241 may also be spaced apart from each other. In some embodiments, the two adjacent second magnetic elements 251 of at least two second magnetic elements 251 may also be spaced apart from each other. For example, the two adjacent second magnetic elements 251 may be spaced apart from each other by a predetermined distance. The two adjacent first magnetic elements 241 of the at least two first magnetic elements 241 may be spaced apart from each other or may be abutted against each other.

In some embodiments, a thickness of the first magnetic element 241 is the same as a thickness of the second magnetic element 251. When the driving mechanism 260 drives the second magnetic element 250 to move, the second magnetic element 250 can be driven to a position with one width of the second magnetic element 251. It can be understood that when the electronic device 20 needs to be in the folded state, the S pole of the first magnetic element 241 directly faces to the n pole of the second magnetic element 251, the N pole of the first magnetic element 241 directly faces to the s pole of the second magnetic element 251, and thus, the first magnetic mechanism 240 and the second magnetic mechanism 250 generate an attractive force to keep the electronic device 20 in the folded state. In addition, during folding of the electronic device 20, when a distance between the first housing 210 and the second housing 220 is less than a certain angle, the electronic device 20 is automatically folded by the attractive force generated by the first magnetic mechanism 240 and the second magnetic mechanism 250. When the electronic device 20 needs to be in the unfolded state, the second magnetic mechanism 250 is driven by the driving mechanism 260 to move a position, for example, a position where the second magnetic mechanism 250 can be moved by one width of the second magnetic member 251, thus the S pole of the first magnetic element 241 in the first magnetic mechanism 240 directly faces to the s pole of the second magnetic element 251 in the second magnetic mechanism 250, and the N pole of the first magnetic element 241 in the first magnetic mechanism 240 directly faces to the n pole of the second magnetic element 251 in the second magnetic mechanism 250. In this way, a repulsive force can be generated between the first magnetic mechanism 240 and the second magnetic mechanism 250 to keep the electronic device 20 unfold at a certain angle, and the user can manually unfold the device.

In other embodiments, the first magnetic mechanism 240 may include at least two first magnetic elements 241, and the second magnetic mechanism 250 may include one second magnetic element 251. When the first housing 210 and the second housing 220 are in the folded state, a projection of the one second magnetic element 251 on the first housing 210 overlaps with one first magnetic element 241 of the first magnetic elements 241. The driving mechanism 260 may drive the second magnetic element 251 to move between the first position and the second position to have the first magnetic mechanism 240 and the second magnetic mechanism 250 switched between the state of being attracted together and the state of being repelled to be separated from each other. For example, the first magnetic mechanism 240 may include a first magnetic element 241a and a first magnetic element 241b, and the second magnetic mechanism 250 may include a second magnetic element 251b. When the second magnetic element 251b is located at the first position, the second magnetic element 251b corresponds to the first magnetic element 241b, at this time, the third magnetic pole of the second magnetic element 251b directly faces to the first magnetic pole of the first magnetic element 241b, and an attractive force is generated between the second magnetic element 251b and the first magnetic element 241b to attract the first magnetic mechanism 240 and the second magnetic mechanism together. When the second magnetic element 251b is located at the second position, the second magnetic element 251b corresponds to the first magnetic element 241a, at this time, the third magnetic pole of the second magnetic element 251a directly faces to the second magnetic pole of the first magnetic element 241a, and a repulsive force is generated between the second magnetic element 251a and the first magnetic element 241a to have the first magnetic mechanism 240 and the second magnetic mechanism 240 repelled to be separated from each other.

Among the at least two first magnetic elements 241, different first magnetic elements 241 have different magnetic intensities. For example, the first magnetic mechanism 240 may include three first magnetic elements, namely, the first magnetic element 241a, the first magnetic element 241b, and the first magnetic element 241c as described above. The magnetic intensity of the first magnetic element 241a may be greater than that of the first magnetic element 241b and the first magnetic element 241c, and the magnetic intensity of the first magnetic element 241b may be greater than that of the first magnetic element 241c. The second magnetic mechanism 250 may include a second magnetic element 251b as described above. The electronic device 20 (or the processor) may control the driving mechanism 260 to drive the second magnetic element 251b to different positions to have the second magnetic element 251b faced to the first magnetic elements 241 with different magnetic intensities. For example, when the electronic device 20 needs to be unfolded, the processor may control the driving mechanism 260 to drive the second magnetic element 251b to face the first magnetic element 241a or the first magnetic element 241c based on an angle value of the electronic device 20 that needs to be unfolded. When the unfolding angle of the electronic device 20 is small, the processor may control the driving mechanism 260 to drive the second magnetic element 251b to face the first magnetic element 241c. When the unfolding angle of the electronic device 20 is large, the processor may control the driving mechanism 260 to drive the second magnetic element 251b to face the first magnetic element 241a. It can be understood that since the magnetic intensities of different the first magnetic elements 241 are different, when they are faced to the second magnetic element 251, the repulsive force or attractive force generated between the second magnetic element 251 and the first magnetic element 241 corresponding thereto is also different. Under the action of different repulsive force or attractive force, the separating distance and the degree of attaching between the first housing 210 and the second housing 220 are also different, which can make folded modes of the foldable electronic device more diversified.

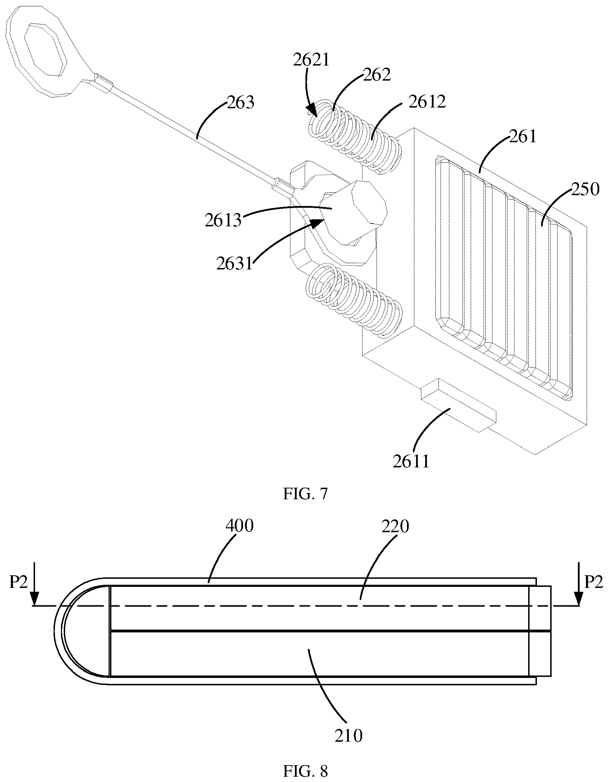

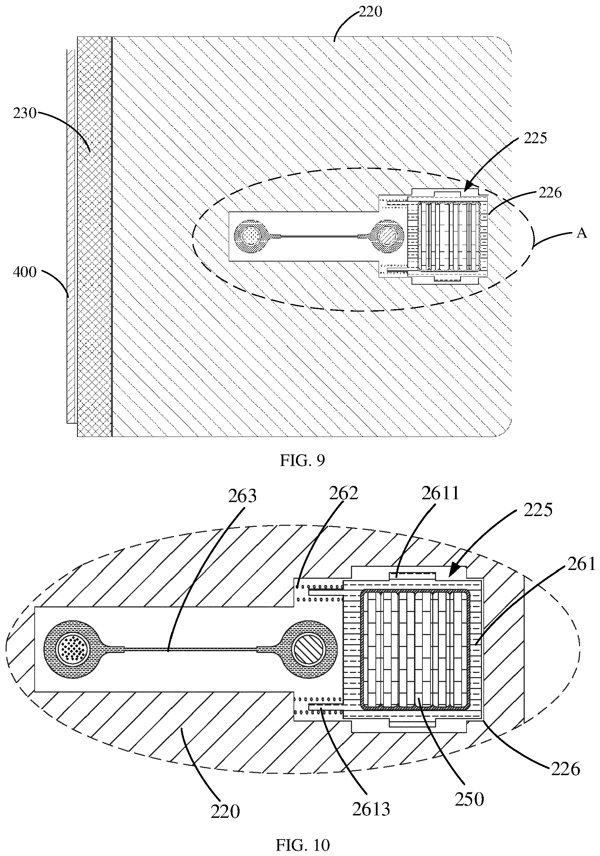

As illustrated in FIG. 7 to FIG. 10, FIG. 7 illustrates a schematic structural diagram of a driving mechanism and a second magnetic mechanism in the electronic device illustrated in FIG. 4. FIG. 8 illustrates a third schematic structural diagram of an electronic device in a folded state according to an embodiment of the present disclosure. FIG. 9 illustrates a schematic cross-sectional structural diagram of the electronic device illustrated in FIG. 8 taken along a P2-P2 direction. FIG. 10 illustrates a schematic structural diagram of an A area in the electronic device illustrated in FIG. 9. The driving mechanism 260 may include a bracket 261 and a driving element. The bracket 261 is connected to the driving element. The second magnetic mechanism 250 is disposed on the bracket 261. The driving element is used to drive the bracket 261 to move to make the second magnetic mechanism 250 move following the bracket 261. The driving element may be a motor, a gear box, an electromagnet, or other mechanism that can provide a driving force. The bracket 261 is provided with a limit block such as a limit block 2611, the limit block 2611 cooperates with a limit groove such as a limit groove 225 provided on the second housing 220 to limit a movement direction of the bracket 261. The driving element can drive the bracket 261 to move. During the movement of the bracket 261, the limit groove 225 cooperates with the limit block 2611 to limit the movement trajectory of the bracket 261, therefore the second magnetic mechanism 250 provided on the bracket 261 can move according to a preset trajectory.

The driving mechanism 260 may further include an elastic element such as an elastic element 262, an end of the elastic element 262 is connected to the bracket, another end of the elastic element 262 abuts against the second housing 220. For example, the second housing 220 may include a case such as a case 226, which is accommodated inside the second housing 220. The case 226 is provided with a storage space in which the driving mechanism 260 and the second magnetic mechanism 250 are accommodated. The limit groove 225 is provided on the case 226. The end of the elastic element 262 is connected to the bracket 261, and another end of the elastic element 262 abuts against a side wall of the case 226. The driving element can control the bracket 261 to move in a first direction to a preset position, the second magnetic mechanism 250 moves following the bracket 261 in the first direction. When the bracket 261 moves in the first direction, the elastic element 262 is pressed, and at this time, the elastic element 262 is pressed to generate an elastic force. When the second magnetic mechanism 250 needs to be moved to the original position, the electronic device 20 can cut off a power supply of the driving element, at this time, a driving force of the driving element disappears, and the elastic force of the pressed elastic element 262 is released, which can urge the bracket 261 to move to the original position in a second direction, and drive the second magnetic mechanism 250 to return to the original position. Relative to back-and-forth motion of the driving element driving the bracket 261, the structure of the driving mechanism according to the embodiment of the present disclosure can make the driving element work only once to realize the back-and-forth motion of the bracket 261, and can reduce the power consumption of the driving mechanism 260 to the electronic device 20. The first direction refers to a direction close to the side wall of the case 226 that abuts against the elastic element 262, and the second direction refers to a direction facing away from the side wall of the case 226 that abuts against the elastic element 262.

The processor may be configured to control working states of the driving mechanism 260 based on different signals to make the first magnetic mechanism 240 and the second magnetic mechanism 250 be mutually attracted together or be mutually repelled to be separated from each other. For example, the processor may receive a third signal and control, based on the third signal, the driving element to work. At this time, the driving element can drive the bracket 261 to move to the first position and press the elastic element 262, therefore the elastic element 262 is elastically deformed and in a compressed state. At this time, an attractive force can be generated between the second magnetic mechanism 250 and the first magnetic mechanism 240 to make the second magnetic mechanism 250 and the first magnetic mechanism 240 mutually attracted together, and the first housing 210 and the second housing 220 are rotated relative to each other in a direction of mutual attracting, and the first housing 210 and the second housing 220 are kept in the folded state. The processor may also receive a fourth signal and control, based on the fourth signal, the driving mechanism 260 not to work. At this time, a towing force originally applied to the bracket 261 disappears, the elastic element 262 can return from the original compressed state to the extended state, and the bracket 261 is driven to the second position, therefore a repulsive force can be generated between the second magnetic mechanism 250 and the first magnetic mechanism 240 to make the second magnetic mechanism 250 and the first magnetic mechanism 240 mutually repelled to be separated from each other, the first housing 210 and the second housing 220 are rotated relative to each other in a direction mutual repelling, and thus the first housing 210 and the second housing 220 unfold at a certain angle.

The bracket 261 may be connected to the elastic element 262 through a first connection element such as the first connection element 2612. For example, the first connection element 2612 may be provided on the side wall of the bracket 261 and protrude from the side wall of the bracket 261. The elastic element 262 may be provided with a first through hole such as the first through hole 2621. A portion of the elastic element 262 is sleeved on the first connection element 2612 through the first through hole 2621, and another portion of the elastic element 262 is exposed outside. It can be understood that the first connection element 2612 can limit the deformation direction of the elastic element 262, therefore the elastic element 262 can be deformed along an axial direction of the first connection element 2612 during the deformation, and can avoid the elastic element 262 from being deformed in other directions (such as in a radial direction of the elastic element 262). The number of the elastic element 262 in the embodiment of the present disclosure may be two. The number of the first connection element 2612 may be the same as the number of the elastic element 262. The two elastic elements 262 are spaced apart from each other and sleeved on the two first connection elements 2612 respectively. The arrangement of the two elastic elements 262 can equalize the force of the bracket 261, the bracket 261 does not deflect during the movement. It should be noted that the number of the elastic element 262 in the embodiment of the present disclosure can also be other values, such as one, three or four, and the embodiment of the present disclosure is not limited to this.

The bracket 261 may further include a second connection element such as a second connection element 2613, the second connection element 2613 is arranged between the two first connection elements 2612, and the second connection element 2613 is used to connect with a towing element such as a towing element 263, which can generate a towing force under the driving of the driving element to tow the bracket 261 to move. The towing element 263 may include a second through hole such as a second through hole 2631, and the second connection element 2613 is sleeved in the second through hole 2631 to connect the towing element 263 with the second connection element 2613.

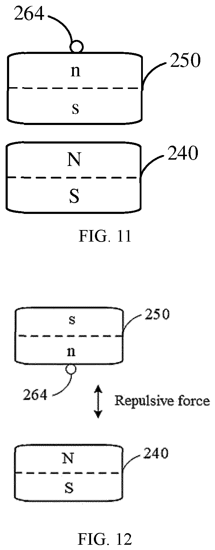

As illustrated in FIG. 11 and FIG. 12, FIG. 11 illustrates a second schematic structural diagram of a first magnetic mechanism and a second magnetic mechanism mutually attracted together in the electronic device illustrated in FIG. 4, and FIG. 12 illustrates a second schematic structural diagram of a first magnetic mechanism and a second magnetic mechanism mutually repelled to be separated from each other in the electronic device illustrated in FIG. 4. In other embodiments, the driving mechanism 260 may include a rotating shaft, such as a rotating shaft 264, which is connected to the second magnetic mechanism 250, and the driving element may drive the second magnetic mechanism 250 to rotate around the rotating shaft 264 to change a magnetic pole orientation of the second magnetic mechanism 250. For example, the first magnetic pole of the first magnetic mechanism 240 faces toward the outside of the first housing 210 from the inside of the first housing 210, and the second magnetic pole of the first magnetic mechanism 240 faces toward the inside of the first housing 210 from the outside of the first housing 210. When the electronic device 20 needs to be in the folded state, the driving element can drive the second magnetic mechanism 250 to rotate clockwise around the rotating shaft 264, so as to make the fourth magnetic pole of the second magnetic mechanism 250 be faced to the second magnetic pole of the first magnetic mechanism 240. At this time, the magnetic poles of the first magnetic mechanism 240 and the second magnetic mechanism 250 are unlike magnetic poles, the first magnetic mechanism 240 and the second magnetic mechanism 250 can generate the attractive force to make the electronic device 20 be kept in the folded state. When the electronic device 20 needs to be in the unfolded state, the driving element can drive the second magnetic mechanism 250 to rotate counterclockwise around the rotating shaft 264, so as to make the third magnetic pole of the second magnetic mechanism 250 is faced to the second magnetic pole of the first magnetic mechanism 240. At this time, the magnetic poles of the first magnetic mechanism 240 and the second magnetic mechanism 250 are like magnetic poles, a repulsive force can be generated between the first magnetic mechanism 240 and the second magnetic mechanism 250 to make the electronic device 20 unfold at a certain angle, which facilitates the user to manually unfold the device.

It should be noted that when the electronic device 20 needs to be in the folded state, the driving element may drive the second magnetic mechanism 250 to rotate counterclockwise around the rotating shaft 264. When the electronic device needs to be in the unfolded state, the driving element may drive the second magnetic mechanism 250 to rotate clockwise around the rotating shaft 264.

It can be understood that a rotating direction of the second magnetic mechanism 250 is not limited in the embodiments of the present disclosure, as long as the corresponding relationship between the magnetic poles of the second magnetic mechanism 250 and the magnetic poles of the first magnetic mechanism 240 can be changed, and thereby the first magnetic mechanism 240 and the second magnetic mechanism 250 can be switched between the state of being attracted together and the state of being repelled to be separated from each other.

As illustrated in FIG. 1 and FIG. 2, when the electronic device 20 is in a horizontal folded mode, the first magnetic mechanism 240 may be disposed close to the second side 212, so as to make the first magnetic mechanism 240 be located at the side edge of the electronic device 20, therefore the user can easily unfold or fold the electronic device 20. Of course, the folded mode of the electronic device 20 may also be a vertical folded mode. If the electronic device 20 is vertically folded, the first magnetic mechanism 240 may be disposed close to the first side 211. In the present disclosure, the horizontal folded mode refers to a mode of folding along a length direction of the electronic device 20, and the vertical folded mode refers to a mode of folding along a width direction of the electronic device 20. It can be understood that, by disposing the first magnetic mechanism 240 at the edge position of the first housing 210, the magnetic force of the first magnetic mechanism 240 can mainly act on the edge position of the first housing 210. Thus, compared with disposing the first magnetic mechanism 240 at a middle position of the first housing 210, when the same magnetic force is applied, the first housing 210 and the second housing 220 can be separated by a greater distance. It should be noted that the folded mode of the electronic device 20 is not limited to the horizontal folded mode and the vertical folded mode, for example, it may be a folded mode at any other angle.

As illustrated in FIG. 1, the electronic device 20 may further include a foldable display screen such as a foldable display screen 400, which may adopt a flexible organic light emitting diode (OLED) display screen, a flexible liquid crystal display (LCD), or other types of foldable display screens. The foldable display screen 400 is used to show a screen. The foldable display screen 400 may have a regular shape, such as a rectangular parallelepiped structure or a rounded rectangular structure, and the foldable display screen 400 may also have an irregular shape.

It should be noted that when the first housing 210 and the second housing 220 are in a folded state, the foldable display screen 400 may be exposed outside the first housing 210 and the second housing 220, or may be hidden inside the first housing 210 and the second housing 220.

The electronic device provided in the embodiments of the present disclosure has been described in detail above. In this paper, specific examples are applied to explain the principles and embodiments of the present disclosure. The description of the above embodiments is only used to help understand the present disclosure. Meanwhile, for those skilled in the art, there will be changes in the specific implementation mode and application scope according to the idea of the present disclosure. To sum up, the contents of this specification should not be construed as limiting the present disclosure.

## Claims

1. An electronic device, comprising:
a first housing, provided with a first magnetic mechanism;
a second housing, rotatably connected to the first housing, wherein the second housing is provided with a second magnetic mechanism; and
a driving mechanism, connected to the second magnetic mechanism, wherein the driving mechanism is configured to drive the second magnetic mechanism to move to have the second magnetic mechanism and the first magnetic mechanism mutually attracted together or mutually repelled to be separated from each other and thereby to drive the first housing and the second housing to rotate relatively to each other.

2. The electronic device according to claim 1, wherein the first magnetic mechanism comprises at least two first magnetic elements arranged side by side, and magnetic poles of adjacent two of the at least two first magnetic elements are unlike magnetic poles;
wherein the second magnetic mechanism comprises at least two second magnetic elements arranged side by side, and magnetic poles of adjacent two of the at least two second magnetic elements are unlike magnetic poles;
wherein the driving mechanism is configured to drive the at least two second magnetic elements to move between a first position and a second position to make the at least two second magnetic elements each correspond to different ones of the at least two first magnetic elements, and thereby magnetic poles of at least some of the at least two second magnetic elements and the first magnetic elements corresponding thereto are unlike magnetic poles when the at least two second magnetic elements are located at the first position, and magnetic poles of at least some of the at least two second magnetic elements and the first magnetic elements corresponding thereto are like magnetic poles when the at least two second magnetic elements are located at the second position.

3. The electronic device according to claim 2, wherein a number of the first magnetic elements in the first magnetic mechanism is one more than a number of the second magnetic elements in the second magnetic mechanism.

4. The electronic device according to claim 2, wherein adjacent two of the at least two second magnetic elements are abutted against each other; or adjacent two of the at least two second magnetic elements are spaced apart from each other.

5. The electronic device according to claim 4, wherein adjacent two of the at least two first magnetic elements are abutted against each other; or adjacent two of the at least two first magnetic elements are spaced apart from each other.

6. The electronic device according to claim 5, wherein a thickness of one of the first magnetic elements is the same as a thickness of one of the second magnetic elements.

7. The electronic device according to claim 1, wherein the first magnetic mechanism comprises at least two first magnetic elements arranged side by side, and magnetic poles of adjacent two of the at least two first magnetic elements are unlike magnetic poles;
wherein the second magnetic mechanism comprises one second magnetic element; the driving mechanism is configured to drive the second magnetic element to move between a first position and a second position to make the second magnetic element correspond to different ones of the at least two first magnetic elements, and thereby a magnetic pole of the second magnetic element and a magnetic pole of the first magnetic element corresponding thereto are unlike magnetic poles when the second magnetic element is located at the first position, and a magnetic pole of the second magnetic element and a magnetic pole of the first magnetic element corresponding thereto are like magnetic poles when the second magnetic element is located at the second position.

8. The electronic device according to claim 7, wherein magnetic intensities of the first magnetic elements arranged at different positions are different in the at least two first magnetic elements arranged side by side.

9. The electronic device according to claim 1, wherein the driving mechanism comprises a bracket and a driving element connected to the bracket, the second magnetic mechanism is disposed on the bracket, and the driving element is configured to drive the bracket to move and thereby to make the second magnetic mechanism move following the bracket.

10. The electronic device according to claim 9, wherein the second housing is provided with a limit groove, the bracket is provided with a limit block, the limit block is disposed in the limit groove, and the limit groove is configured to cooperate with the limit block to limit a movement track of the bracket.

11. The electronic device according to claim 9, wherein the driving mechanism further comprises an elastic element, an end of the elastic element is connected to the bracket, another end of the elastic element abuts against the second housing, and the elastic element is configured to generate elastic deformation and thereby to switch between a compressed state and an extended state;
wherein the elastic element is deformed to be in the compressed state and the bracket is moved to a preset position when the driving element drives the bracket to move; and the elastic element is switched from the compressed state to the extended state and the bracket moves to an initial position when the driving element does not drive the bracket to move.

12. The electronic device according to claim 11, wherein the bracket is connected to the elastic element through a first connection element, and the first connection element is configured to limit a deformation direction of the elastic element.

13. The electronic device according to claim 12, wherein the first connection element is disposed on a side wall of the bracket and protrudes from the side wall of the bracket, the elastic element is provided with a first through hole, a portion of the elastic element is sleeved on the first connection element through the first through hole, and another portion of the elastic element is exposed outside.

14. The electronic device according to claim 13, wherein a number of each of the first connection element and the elastic element is two, and the two elastic elements are spaced apart from each other and sleeved on the two first connection elements respectively.

15. The electronic device according to claim 14, wherein the driving mechanism further comprises a towing element connected to the driving element, the bracket further comprises a second connection element, the second connection element is disposed between the two first connection elements, the second connection element is connected to the towing element, and the driving element is configured to drive the towing element to tow the bracket to move.

16. The electronic device according to claim 15, wherein the towing element is provided with a second through hole, and the second connection element is sleeved in the second through hole.

17. The electronic device according to claim 1, wherein the driving mechanism comprises a rotating shaft and a driving element, the rotating shaft is connected to the second magnetic mechanism, and the driving element is configured to drive the second magnetic mechanism to rotate around the rotating shaft and thereby make magnetic poles of the second magnetic mechanism and the first magnetic mechanism be switched between unlike magnetic poles and like magnetic poles.

18. An electronic device, comprising:
a first housing, provided with a first magnetic mechanism;
a second housing, rotatably connected to the first housing, wherein the second housing is provided with a second magnetic mechanism; and
a driving mechanism, configured to drive the second magnetic mechanism to move on the second housing; and
a processor, electrically connected to the driving mechanism;
wherein the processor is configured to control, based on different signals, the driving mechanism to drive the second magnetic mechanism to move to different positions and thereby to have the second magnetic mechanism and the first magnetic mechanism mutually attracted together or mutually repelled to be separated from each other.

19. The electronic device according to claim 18, wherein the first magnetic mechanism comprises at least two first magnetic elements arranged side by side, and magnetic poles of adjacent two of the at least two first magnetic elements are unlike magnetic poles;
wherein the second magnetic mechanism comprises at least two second magnetic elements arranged side by side, and magnetic poles of adjacent two of the at least two second magnetic elements are unlike magnetic poles;
wherein the driving mechanism is configured to control, based on the different signals, the driving mechanism to drive the second magnetic mechanism to move between a first position and a second position to make the at least two second magnetic elements each correspond to different ones of the at least two first magnetic elements and thereby magnetic poles of at least some of the at least two second magnetic elements and the first magnetic elements corresponding thereto are unlike magnetic poles when the at least two second magnetic elements are located at the first position, and magnetic poles of at least some of the at least two second magnetic elements and the first magnetic elements corresponding thereto are like magnetic poles when the at least two second magnetic elements are located at the second position.

20. The electronic device according to claim 18, wherein the driving mechanism comprises a bracket, a driving element, and an elastic element connected to one another; the second magnetic mechanism is disposed on the bracket, the driving element is configured to drive the bracket to move and thereby make the second magnetic mechanism move following the bracket; an end of the elastic element is connected to the bracket, another end of the elastic element abuts against the second housing, and the elastic element is configured to generate elastic deformation and thereby to switch between a compressed state and an extended state;
wherein the processor is configured to:
receive a third signal, and control based on the third signal the driving element to drive the bracket to move to a first position and press the elastic element to make the elastic element be switched to the compressed state, and thereby an attractive force is generated between the second magnetic mechanism and the first magnetic mechanism;
receive a fourth signal, and control based on the fourth signal the driving element to drive the bracket to move to a second position and thereby make the elastic element be switched to the extended state, and thereby a repulsive force is generated between the second magnetic mechanism and the first magnetic mechanism 240.
